Europäisches Patentamt

European Patent Office

Office européen des brevets

(11) Numéro de publication: **0 370 443 B1**

## FASCICULE DE BREVET EUROPEEN

(45) Date de publication de fascicule du brevet: **06.10.93** (51) Int. Cl.5: **H01S 3/103**, H01S 3/06

(21) Numéro de dépôt: **89121469.4**

(22) Date de dépôt: **20.11.89**

(54) Laser à semi-conducteur accordable.

(30) Priorité: **25.11.88 FR 8815467**

(43) Date de publication de la demande:
**30.05.90 Bulletin 90/22**

(45) Mention de la délivrance du brevet:
**06.10.93 Bulletin 93/40**

(84) Etats contractants désignés:
**DE FR GB IT NL**

(56) Documents cités:
EP-A- 0 246 959
EP-A- 0 300 790
US-A- 4 680 769
US-A- 4 775 980

ELECTRONICS LETTERS, vol. 24, no. 8, 14 avril 1988, pages 503-505; Y. KOTAKI et al.: "Tunable DBR laser with wide tuning range"

IEEE JOURNAL OF OUANTUM ELECTRONICS, vol. OE-21, no. 5, mai 1985, pages 415-417, IEEE, New York, US; M. KITAMURA et al.: "Lasing mode and spectral linewidth control by phase tunable distributed feedback laser diodes with double channel planar buried heterostructure (DFB-DC-PBH LD's)"

(73) Titulaire: **ALCATEL N.V.**
**Strawinskylaan 341**
**(World Trade Center)**
**NL-1077 XX Amsterdam(NL)**

(72) Inventeur: **Brosson, Philippe**
**6 place de la Fontaine au Curé**
**F-91470 Forges les Bains(FR)**
Inventeur: **Jacquet, Joel**
**Résidence les Bouleaux**
**rue F. Leroux**
**F-91400 Orsay(FR)**
Inventeur: **Artigue, Claude**
**47, rue Sarrette**
**F-75014 Paris(FR)**
Inventeur: **Leclerc, Daniel**
**26bis boulevard Carnot**
**F-92340 Bourg La Reine(FR)**
Inventeur: **Benoit, Jacques**
**2, allée de Persépolis**
**F-91400 Orsay(FR)**

(74) Mandataire: **Weinmiller, Jürgen et al**
**Lennéstrasse 9**
**Postfach 24**
**D-82336 Feldafing (DE)**

PATENT ABSTRACTS OF JAPAN, vol. 9, no. 8 (E-289)[1731], 12 janvier 1985; & JP-A-59 155 983 (SHARP K.K.) 05-09-1984

## Description

La présente invention concerne une source optique constituée par un laser et elle s'applique notamment aux systèmes de télécommunications à fibres optiques. Il est bien connu que, dans de tels systèmes, l'utilisation d'une détection cohérente permet d'augmenter considérablement aussi bien la distance entre les répéteurs que la capacité de transmission, un tel type de détection du système nécessitant cependant l'emploi de sources optiques monochromatiques accordables en longueur d'onde. Cette accordabilité est nécessaire pour que la longueur d'onde propre à la source qui constitue l'oscillateur local puisse être calée sur celle de la source d'émission. De faibles largeurs de raies de ces sources sont en outre requises pour assurer une détection cohérente efficace.

En ce qui concerne plus particulièrement l'augmentation souhaitée de la capacité de transmission d'informations, un moyen connu consiste à utiliser le multiplexage en fréquence optique en même temps que la détection cohérente. L'accordabilité en longueur d'onde des sources utilisées permet alors de commander électriquement les fréquences optiques de l'onde porteuse et de l'oscillateur local. Une large plage d'accord est donc souhaitée pour accroître le nombre des canaux.

C'est pourquoi le besoin d'un composant optoélectronique intégré alliant une large accordabilité continue en longueur d'onde et de préférence une faible largeur de raie est ressenti depuis plus de cinq années pour constituer de telles sources. Les recherches qu'il a suscité ont donné lieu à de nombreuses publications dont une liste est donnée à la fin de la présente description, et dont la plupart examinent la largeur de la raie obtenue.

La présente invention est par conséquent complémentaire du brevet de J. Robieux sur le multiplexage en fréquence optique (FR 2 586 874)

On sait qu'une source optique monochromatique accordable peut être constituée par un laser à semi-conducteur à réalimentation distribuée dit "laser DFB". Le principe de fonctionnement de ce type de laser est décrit notamment dans la publication C. ARTIGUE, Y. LOUIS, F.POINGT, D. SIGOGNE et J. BENOIT, "Low threshold second order DFB laser emitting at 1.3 micron for high bit rate applications", Proc. IOOC-ECO"85, Venezia, Italy, 33, 1985.

Un laser DFB émet, en principe sur un seul mode et avec une faible largeur de raie, au voisinage d'une longueur d'onde dite de Bragg. La longueur d'onde d'émission est entièrement déterminée par la longueur d'onde équivalente du matériau actif qui constitue la couche active de ce laser, c'est-à-dire par la longueur d'onde de la lumière susceptible d'être amplifiée dans ce matériau, par le pas du réseau de diffraction gravé dans une couche passive adjacente à la couche active, et par l'indice effectif n du mode laser c'est-à-dire par l'indice vu par la lumière qui est guidée dans le guide de lumière constitué par ces couches active et passive, cet indice effectif dépendant des épaisseurs et des indices optiques des différentes couches parcourues par cette lumière. Pour être accordable dans de bonnes conditions un tel laser comporte trois sections qui se succèdent selon sa longueur et qui sont alimentées en courants électriques de manière indépendante.

Divers lasers du type DFB à trois sections sont connus.

Un premier laser connu a été proposé par MURATA (S. MURATA, I. MITO, K. KOBAYASHI, "Tuning ranges for 1.5 micron wavelength tunable DBR laser") Electron.Lett., Vol 24, p 577, 1988. Un deuxième laser connu a été proposé par les présentes inventeurs aux Journées Nationales d'Optique Guidée en mars 1988 à Lannion (France). Ces lasers connus et un laser selon la présente invention comportent divers éléments qui sont communs quant à certaines de leurs fonctions. Des éléments communs à ce deuxième laser connu et à ce laser selon la présente invention vont maintenant être indiqués de manière à préciser le contexte technique de la présente invention :

- une plaquette semi-conductrice monolithique s'étendant selon une direction longitudinale et constituée de couches qui ont des compositions et des dimensions transversales diverses, ces dimensions transversales étant des largeurs et des épaisseurs, ces largeurs étant éventuellement juxtaposées selon une direction latérale, ces épaisseurs étant superposées selon une direction de superposition, lesdites largeur et épaisseur de chacune de ces couches définissant une section de cette couche, ces couches constituant :
- un guide de lumière interne s'étendant selon ladite direction longitudinale et interposé, selon lesdites directions de superposition et latérale, entre des couches de confinement qui ont des indices optiques moins élevés de manière à guider une lumière se propageant selon cette direction longitudinale, ce guide de lumière comportant lui-même au moins une couche active dans laquelle une bande d'énergie interdite présente une largeur plus petite que dans les couches adjacentes, une première et une deuxième dites couches de confinement présentant un premier et un deuxième types de conductivité opposés pour que, si des courants électriques d'injection passent de l'une à l'autre de

3

ces deux couches selon ladite direction de superposition, ces courants traversent ce guide de lumière et y fassent apparaître des densités de porteurs libres propres à y engendrer un gain optique et/ou à y commander un indice optique,

- et trois sections qui se succèdent selon ladite direction longitudinale et qui sont
- une section d'amplification dans laquelle ladite couche active présente une épaisseur d'amplification propre à permettre une amplification de ladite lumière,
- une section d'accord de phase,
- et une section de réseau qui est située à une première extrémité dudit guide de lumière et dans laquelle l'épaisseur d'une couche de réseau appartenant audit guide de lumière varie alternativement selon ladite direction longitudinale pour former un réseau de diffraction présentant un pas et pour que ce réseau contribue à former pour ladite lumière un réflecteur distribué de Bragg ayant un pas équivalent commandable, le rapport de ce pas équivalent audit pas de réseau étant commandable par l'intermédiaire de l'indice optique commandable de ladite couche active dans ladite section de réseau, le laser comportant en outre
- des électrodes d'amplification disposées dans ladite section d'amplification pour y faire passer un courant d'amplification qui constitue un dit courant d'injection pour faire apparaître dans ladite couche active un gain optique positif propre à créer et/ou à amplifier ladite lumière,
- des électrodes d'accord de phase disposées dans ladite section d'accord de phase pour y faire passer un courant d'accord de phase qui constitue un dit courant d'injection pour commander l'indice optique de ladite couche active et pour commander ainsi la longueur optique de ladite section d'accord de phase vis-à-vis de ladite lumière,
- des électrodes de commande de réseau disposées dans ladite section de réseau pour y faire passer un courant de commande de réseau qui constitue un dit courant d'injection pour commander ledit pas équivalent dudit réflecteur distribué,
- et un deuxième réflecteur à une deuxième extrémité dudit guide de lumière à distance de ladite section de réseau de manière à constituer un oscillateur laser propre à émettre une dite lumière dont une fréquence centrale peut être commandée par l'intermédiaire de la valeur dudit courant de commande de réseau, un fonctionnement monomode stable de cet oscillateur pouvant être obtenu en commandant une valeur correspondante dudit courant d'accord de phase.

Ces deux lasers connus présentent en outre les dispositions complémentaires suivantes qui leurs sont communes avec le laser selon la présente invention précédemment mentionné :

- Ledit guide de lumière comporte en outre une couche passive qui s'étend sur toute la longueur de ce guide et qui constitue ladite couche de réseau dans ladite section de réseau.
- Une première dite couche de confinement d'un premier dit type de conductivité, ladite couche active, ladite couche passive et une deuxième dite couche de confinement d'un deuxième dit type de conductivité opposé au premier se suivent selon ladite direction de superposition.

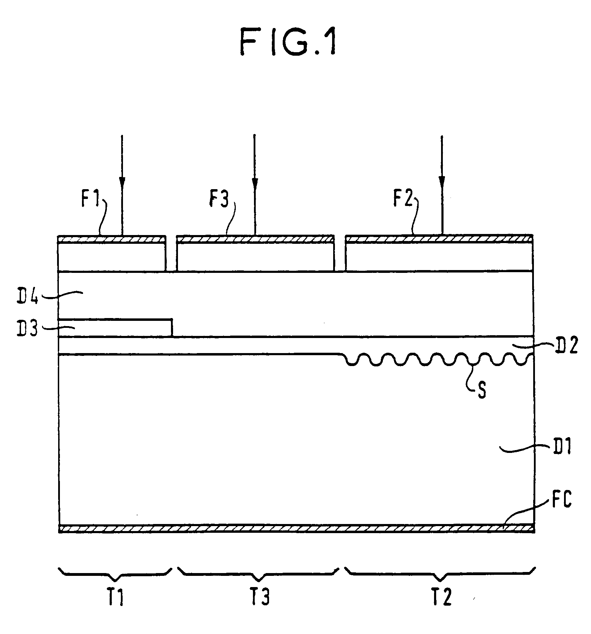

Le premier laser connu précédemment mentionné comporte les mêmes éléments sauf que ladite couche active est limitée à la section d'amplification, ledit pas équivalent dans la section de réseau et la longueur optique de ladite section d'accord de phase étant commandées par l'intermédiaire de l'indice optique de ladite couche passive. Ce premier laser connu est représenté sur la figure 1. Il comporte successivement, selon ladite direction de superposition, une électrode commune FC, une première couche de confinement D1, une couche passive D2, une couche active D3, une deuxième couche de confinement D4 et trois électrodes qui sont superposées à des couches de contact à faible résistivité et qui sont une électrode d'amplification F1, une électrode de commande de réseau F2 et une électrode d'accord de phase F3. Selon la direction longitudinale il comporte la section d'amplification T1 qui contient la totalité de la couche active, la section d'accord de phase T3 et la section de réseau T2 qui contient un réseau de diffraction S formé dans la couche D2.

L'accord de la longueur d'onde est obtenu par la commande du courant de commande de réseau dans la section T2

Les porteurs libres c'est-à-dire les porteurs de charges ainsi injectés dans la section T2 induisent une diminution de l'indice optique dans la couche D2 par effet plasma ce qui se traduit par une variation de l'indice effectif. A cette variation de l'indice effectif correspond une variation approximativement proportionnelle de la longueur d'onde de Bragg. La couche passive D2 constitue donc dans cette section la couche de commande précédemment mentionnée. Le courant d'accord de phase permet d'ajuster la phase en jouant sur l'indice effectif de la couche D2 dans la section T3 cette couche constituant là aussi la couche de commande. Cet ajustement de phase permet d'obtenir une émission monomode à la longueur d'onde de Bragg qui a été commandée comme indiqué ci-dessus par le courant de commande de réseau. Quant au courant dans la section d'amplification T1, il est ajusté de manière à maintenir une puissance optique de sortie constante.

Ce laser a permis un accord continu sur une plage de 4,4 nm au voisinage de 1500 nm à une puissance de sortie de 1 mW. Cependant à une puissance de 5 mW cette plage est réduite à 2.8 nm. Cette réduction de la plage d'accord en fonction de la puissance a deux conséquences : D'une part elle limite le nombre de canaux dans le cas du multiplexage en longueur d'onde. D'autre part elle empêche d'utiliser une puissance élevée et donc d'obtenir une faible largeur de raie parce que la largeur de raie est inversement proportionnelle à la puissance du laser.

Par ailleurs, lorsqu'on augmente le courant de commande de réseau pour modifier la longueur d'onde, les pertes optiques dans les sections T2 et T3 augmentent en raison de l'absorption de la lumière par les porteurs libres. Elles provoquent alors un échauffement qui induit une augmentation de l'indice optique s'opposant à la diminution due à l'effet plasma. Ces deux contributions antagonistes font apparaître une limite pour la variation de la longueur d'onde.

En outre pour d'importantes variations de longueur d'onde, les pertes optiques dans les sections T2 et T3 provoquent une forte augmentation de la valeur de seuil du courant d'amplification, cette valeur étant couramment appelée courant seuil du laser et passant de 18 à 70 mA.

Le deuxième laser connu précédemment mentionné diffère du premier par le fait que la couche active se prolonge à épaisseur constante dans les sections d'accord de phase et de réseau. Il évite certains des inconvénients du premier laser connu en utilisant l'effet dit "de dispersion anormale" pour induire la variation d'indice optique au lieu de l'effet plasma qui est deux ou trois fois moins important. La mise en oeuvre de cet effet nécessite que les sections d'accord de phase et de réseau comportent une couche active c'est-à-dire constituée par le même matériau que dans la section d'amplification ou du moins par un matériau permettant un amplification de lumière. Les effets thermiques liés à l'absorption par porteurs libres sont alors beaucoup moins importants car la même variation de longueur d'onde peut s'obtenir en injectant beaucoup moins de porteurs que précédemment. Cependant lorsqu'on augmente un courant d'injection de manière telle que l'une des sections d'accord de phase ou de réseau commence à amplifier la lumière, la densité de porteurs injectés dans cette section sature et ceci crée une limite pour la variation de longueur d'onde.

La présente invention a notamment pour but d'obtenir une limite de variation de longueur d'onde plus élevée que dans ces premier et deuxième lasers connus. Elle a en même temps pour but de permettre d'accorder un laser à semi-conducteur monochromatique de manière continue sur une plage ainsi élargie, et/ou de diminuer la largeur de raie de la lumière émise par ce laser.

La présente invention est définie dans les revendications indépendantes 1 et 2.

Ladite dimension transversale de la couche active peut être l'épaisseur et/ou la largeur de la couche active.

A l'aide de la figure schématique 2 ci-jointe on va décrire plus particulièrement ci-après, à titre d'exemple non limitatif, un laser selon la présente invention.

La figure 1 a déjà été décrite et représente une vue du premier laser connu précédemment mentionné, en coupe par un plan longitudinal vertical, ladite direction du superposition étant verticale.

La figure 2 représente une vue d'un laser selon la présente invention en coupe par un plan longitudinal vertical.

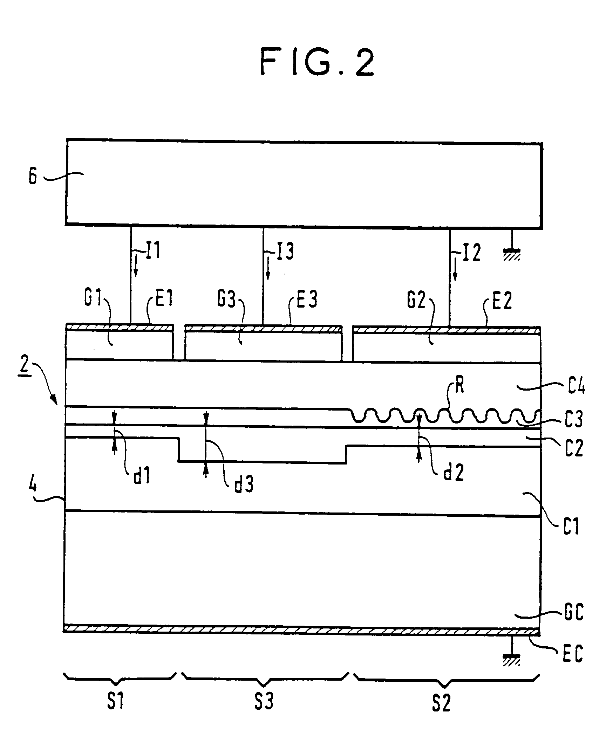

Le laser selon la présente invention représenté à la figure 2 comporte les éléments essentiels communs précédemment mentionnés, notamment une plaquette semi-conductrice monolithique 2. Cette plaquette est constituée de couches C1, C2, C3, C4, ledit guide de lumière C2, C3 étant interposé selon ladite direction de superposition, entre deux dites couches de confinement C1, C4 et, selon ladite direction latérale entre deux couches de confinement latérales non représentées. Ladite couche active de ce guide est représentée en C2 et sa bande d'énergie interdite présente une largeur plus petite que dans des couches C1, C3 qui lui sont adjacentes selon ladite direction de superposition et dans des couches non représentées qui lui sont adjacentes selon ladite direction latérale. Les couches de confinement C1 et C4 présentent lesdits types de conductivité opposés.

Les trois sections sont :
- une section d'amplification S1,
- une section d'accord de phase S3,
- et une section de réseau S2 dans laquelle la couche de réseau C3 forme un réseau de diffraction présentant un pas et contribuant à former un réflecteur distribué de Bragg R. Le rapport du pas équivalent de ce réflecteur au pas propre de ce réseau est commandable par l'intermédiaire de l'indice optique commandable de la couche active C2.
- Les électrodes d'amplification sont les électrodes E1, EC.

- Les électrodes d'accord de phase sont les électrodes E3 et EC et font passer un courant d'accord de phase pour commander l'indice optique de la couche C2.
- Les électrodes de commande de réseau sont représentées en E2 et EC et ledit deuxième réflecteur en 4, ce deuxième réflecteur étant constitué par une face d'extrémité clivée de la pastille 2.

Les électrodes E1, E2, E3 et EC sont constituées de dépôts métalliques formés sur des couches à fortes conductibilités G1, G2, G3, GC, respectivement qui appartiennent à la plaquette 2, l'électrode EC et la couche GC étant communes aux trois sections S1, S2 et S3.

Elles sont reliées à des moyens d'alimentation électrique 6 propres à fournir lesdits courants d'amplification, d'accord de phase et de commande de réseau avec des valeurs propres à assurer ladite amplification dans ladite section d'amplification S1 et à éviter une amplification de ladite lumière dans lesdites sections d'accord de phase S3 et de commande de réseau S2.

Ce laser présente en outre les dispositions communes précédemment mentionnées c'est-à-dire que :

- ledit guide de lumière comporte, outre la couche active C2, une couche passive C3 qui s'étend sur toute la longueur de ce guide, et qui constitue ladite couche de réseau dans ladite section de réseau (S2),
- et que les couches C1, C3 et C4 se suivent selon ladite direction de superposition.

Conformément à la présente invention la couche active C2 présente une dimension transversale accrue dans au moins ladite section de réseau S2. Cette dimension transversale est de préférence l'épaisseur qui, dans cette section, est accrue par rapport à ladite épaisseur d'amplification.

Conformément à une disposition plus particulière et préférée, cette couche active présente une telle dite épaisseur accrue dans les deux sections d'accord de phase et de réseau pour conférer au laser à la fois une plage d'accordabilité continue élargie et une faible largeur de raie.

Pour créer une variation de longueur d'onde $\Delta\lambda$ donnée, le courant I2 injecté dans la section S2 doit satisfaire la relation :

$$\Delta\lambda = \lambda_B \Gamma_2 \frac{d\mu_2}{N_2 dN_2} \sqrt{\frac{I_2}{ed_2 BL_2 W_2}} \qquad (1)$$

$\lambda_B$ est la longueur d'onde de Bragg.

$\mu_2$ et $\mu_3$ sont les indices optiques dans les sections $S_2$ et $S_3$

$n_2$ et $n_3$ sont les indices effectifs dans les sections $S_2$ et $S_3$

$N_2$ et $N_3$ sont les densités de porteurs libres dans les sections $S_2$ et $S_3$.

$L_1$, $L_2$ et $L_3$ sont les longueurs des sections $S_1$, $S_2$ et $S_3$.

$\Gamma_2$ et $\Gamma_3$ sont les confinements optiques dans les sections $S_2$ et $S_3$

$$\frac{d\mu_2}{dN_2} = 15 \times 10^{-21} \text{ cm}^3$$

est la variation de l'indice optique avec la densité de porteurs injectés dans la section $S_2$.

$d_2$, $W_2$ sont l'épaisseur et la largeur de la couche active dans le section $S_2$, $d_3$ étant l'épaisseur de cette couche dans la section S3.

B est le coefficient de recombinaison effectif.

e est la charge de l'électron.

Une émission monomode à la longueur d'onde ainsi définie est obtenue en ajustant le courant $I_3$ injecté dans la section S3 de manière à vérifier la condition d'accord de phase:

$$(L_1 + L_3) \Gamma_2 \Delta\mu_2 = L_3 \Gamma_3 \Delta\mu_3 \qquad (2)$$

Les variations d'indice optique $\Delta\mu_2$ et $\Delta\mu_3$ sont les variations des indices $\mu_2$ et $\mu_3$ et sont reliées aux courants $I_2$ et $I_3$ par les relations

$$\Delta \mu_i = \frac{d\mu_i}{dN_i} \sqrt{\frac{I_i}{ed_i BL_i W_i}} \qquad (3)$$

avec $i = 2, 3$.

Selon la présente invention la limite d'accordabilité est repoussée en augmentant l'épaisseur des couches actives des sections 2 et 3 afin d'augmenter les confinements optiques $\Gamma_2$ et $\Gamma_3$.

On peut noter que l'importante variation de l'indice donc de la plage d'accord de longueur d'onde par l'effet de dispersion anormale est connue en elle même par une publication de BROBERG et al (APL 52, p. 1285, avril 1988) qui décrivait un laser à deux sections. Ce laser présentait des sauts de modes et une plage d'accord discontinue de 9,8 nm.

On peut aussi noter qu'un élargissement d'une plage d'accordabilité a été obtenu (MURATA et al, Elect. Lett., 24, P. 577, mai 1988) grâce à une épaisseur accrue de la couche passive D2 (fig.1) dans le cas d'un accord obtenu par effet plasma dans cette couche. Cependant, l'absorption par porteurs libres conduit alors à une saturation de l'accordabilité par effets thermiques lorsqu'on augmente l'épaisseur de la couche passive.

Dans le cas d'un accord par effet de dispersion anormale selon un mode de réalisation de l'invention, cette augmentation est obtenue grâce à une couche active qui est plus épaisse dans les sections d'accord de phase et de commande de réseau et dans laquelle les limitations thermiques sont beaucoup moins importantes que dans le cas d'un accord par effet plasma. Cependant apparaît dans ce cas une autre limite d'accordabilité qui, comme précédemment indiqué, est atteinte quand la densité des porteurs libres atteint un seuil laser dans l'une des sections $S_2$ ou $S_3$, ce seuil étant celui au delà duquel apparaît un gain positif pour la lumière c'est-à-dire une amplification. Lorsque ce seuil laser est atteint, la densité des porteurs dans la section correspondante ne peut plus augmenter et il devient impossible de faire varier davantage l'indice optique. Afin que cette limite soit atteinte simultanément dans les sections 2 et 3, on peut faire en sorte que $\Delta\mu_2 = \Delta\mu_3$. Dans ce cas l'équation (2) devient

$$\Gamma_2 = \frac{L_3}{L_1 + L_3} \Gamma_3 \qquad (4)$$

L'accordabilité sera d'autant plus grande que $\Gamma_2$ (c'est-à-dire l'épaisseur $d_2$) sera grand, selon l'équation (1). De ce point de vue l'épaisseur $d_3$ peut être choisie plus petite que $d_2$, mais elle peut aussi être choisie égale à $d_2$ pour simplifier la fabrication du laser.

On ne peut cependant pas augmenter les épaisseurs $d_2$ et $d_3$ au-delà de la coupure du 2e mode transverse (430 nm) afin de maintenir une émission monomode transverse. En adoptant cette valeur pour $d_3$, $\Gamma_3 = 0,80$ et en choisissant $L_1 = 200$ micromètres et $L_3 = 800$ micromètres, on obtient d'après l'équation (4) $\Gamma_2 = 0,63$ et donc une épaisseur $d_2 = 290$ nm.

L'épaisseur $d_1$ de la couche active dans la section d'amplification, c'est-à-dire ladite épaisseur d'amplification est choisie de préférence de l'ordre de 150 nm afin de minimiser le courant de seuil. Dans ces conditions, la limite théorique d'accordabilité continue est de 7 nm.

Ces valeurs numériques sont données dans le cas où les couches $C_1$, $C_2$, $C_3$ et $C_4$ présentent les longueurs d'ondes équivalentes et compositions suivantes :

| Couche | Longueur d'onde en micromètres | Composition |
|--------|-------------------------------|-------------|
| C1 | 0,92 | InP |
| C2 | 1,55 | $Ga_{0,42} In_{0,58} A3_{0,90} P_{0,10}$ |
| C3 | 1,35 | $Ga_{0,31} In_{0,60} A3_{0,68} P_{0,32}$ |
| C4 | 0,92 | InP |

Les courants I1, I2 et I3 peuvent alors avoir les valeurs suivantes 20-40, 50 et 80 mA

En relation avec les indications données ci-dessus il apparaît, au moins dans certains cas, préférable d'adopter l'une ou l'autre des dispositions suivantes qui concernent l'épaisseur de la couche active dans la section de réseau et qui sont adoptées dans le laser donné en exemple:

Cette épaisseur est au moins égale à 120% de ladite épaisseur d'amplification.

Cette épaisseur est supérieure à 200 nm.

Cette épaisseur est comprise entre 10 et 25% de la longueur d'onde qu'une lumière susceptible d'être amplifiée dans le matériau de cette couche présente dans ce matériau.

Il doit cependant être compris que la présente invention s'appliquerait tout aussi bien dans d'autres cas où les couches présenteraient des compositions et des longueurs d'ondes équivalentes très différentes des compositions et valeurs indiquées ci-dessus, par exemple pour constituer une source utilisable dans un système de télécommunications comportant des fibres optiques de transmission présentant une transparence maximale à des longueurs d'ondes non utilisée industriellement à l'époque de la présente invention.

En outre la couche active peut être constituée par un puits quantique multiple à confinement séparé, devant permettre ainsi une plus grande efficacité d'accord et une plus faible largeur de raie.

On va maintenant donner la liste de publications précédemment annoncée. Ces publications sont regroupées selon les firmes ou laboratoires dont elles sont issues. Celles qui examinent la largeur de raie sont notées avec le signe*.

. ATT Bell

(International Conference on Semiconductor lasers, p. 120, BOSTON 1988 *

. NEC

(MURATA et al, IEEE J. Quant. Electron QZ-23, p.835, juin 1987) *

(MURATA et al, Electr. Lett. 23, p. 12, janvier 1987) *

(KITAMURA et al, IEEE J. Quant. Elect., QE-21, p.415, mai 1985) *

(MURATA et al, Elect. Lett. 23, p. 403, avril 1987) *

(MURATA et al, Elect. Lett. 24, p. 577, mai 1988)

(MURATA et al, International Conference on Semiconductor lasers,p. 122, BOSTON, sept. 1988). *

. NTT

(YOSHIKUNI et al, Electr. Lett. 22, p. 1153, oct. 1986) *

. TOKYO INSTITUTE OF TECHNOLOGY

(TOHMORI et al, Elect.Lett. 19, p. 656, août 1983)

(TOHMORI et al, Elect. Lett. 22, p. 138, janvier 1986)

. FUJITSU

(KOTAKI et al, Elect. Lett. 23, p. 325, mars 1987)

(KOTAKI et al, Electr. Lett. 24, p. 503, avril 1988) *

(KOTAKI et al, International Conférence on Semiconductor lasers, p. 128, BOSTON, sept, 1988) *

. BTRL

(WESTBROOK, Electr. Lett. 20, p. 957, nov. 1984)

. SWEDISH INSTITUTE FOR MICROELECTRONICS

(BROBERG et al, Appl. Phys. Lett. 52, p. 1285, avril 1988)

## Revendications

**1.** Laser à semi-conducteur accordable à trois sections (S1,S2,S3) se succèdant selon une direction longitudinale et alimentées de courants électriques (I1,I2,I3) de manière indépendante, caractérisé par le fait qu'il présente une dimension transversale accrue de sa couche active par rapport à une section d'amplification (S1) dans une section (S2) munie d'un réflecteur distribué (R) dont le pas équivalent est commandé pour accorder ce laser.

**2.** Laser à semi-conducteur accordable, comportant

- une plaquette semi-conductrice monolithique (2) s'étendant selon une direction longitudinale et constituée de couches (C1, C2, C3, C4) qui ont des compositions et des dimensions transversales diverses, ces dimensions transversales étant des largeurs et des épaisseurs, ces largeurs étant éventuellement juxtaposées selon une direction latérale, ces épaisseurs étant superposées selon une direction de superposition, lesdites largeur et épaisseur de chacune de ces couches définissant une section de cette couche, ces couches constituant :

- un guide de lumière interne (C2, C3) s'étendant selon ladite direction longitudinale et interposé, selon lesdites directions de superposition et latérale, entre des couches de confinement (C1, C4) qui ont des indices optiques moins élevés de manière à guider une lumière se propageant selon cette direction longitudinale, ce guide de lumière comportant lui-même au moins une couche active (C2) dans laquelle une bande d'énergie interdite présente une largeur plus petite que dans les couches adjacentes (C1, C3), une première (C1) et une deuxième (C4) dites couches de confinement présentant un premier et un deuxième types de conductivité opposés pour que, si des courants électriques d'injection (I1,I2,I3) passent de l'une à l'autre de ces deux couches selon ladite direction de superposition, ces courants traversent ce guide de lumière et y fassent apparaître des densités de porteurs libres propres à y engendrer un gain optique et/ou à y commander un indice optique,

- et trois sections qui se succèdent selon ladite direction longitudinale et qui sont
- une section d'amplification (S1) dans laquelle ladite couche active présente une épaisseur d'amplification propre à permettre une amplification de ladite lumière,
- une section d'accord de phase (S3),
- et une section de réseau (S2) qui est située à une première extrémité dudit guide de lumière et dans laquelle l'épaisseur d'une couche de réseau (C3) appartenant audit guide de lumière varie alternativement selon ladite direction longitudinale pour former un réseau de diffraction présentant un pas et pour que ce réseau contribue à former pour ladite lumière un réflecteur distribué de Bragg (R) ayant un pas équivalent commandable, le rapport de ce pas équivalent audit pas de réseau étant commandable par l'intermédiaire de l'indice optique commandable de ladite couche active dans ladite section de réseau,

ce laser comportant en outre

- des électrodes d'amplification (E1, EC) disposées dans ladite section d'amplification pour y faire passer un courant d'amplification qui constitue un dit courant d'injection (I1) pour faire apparaître dans ladite couche active (C2) un gain optique positif propre à créer et/ou à amplifier ladite lumière,
- des électrodes d'accord de phase (E3, EC) disposées dans ladite section d'accord de phase (S3) pour y faire passer un courant d'accord de phase (I3) qui constitue un dit courant d'injection pour commander l'indice optique de ladite couche active (C2) et pour commander ainsi la longueur optique de ladite section d'accord de phase vis-à-vis de ladite lumière,
- des électrodes de commande de réseau (E2, EC) disposées dans ladite section de réseau (S2) pour y faire passer un courant de commande (I2) de réseau qui constitue un dit courant d'injection pour commander ledit pas équivalent dudit réflecteur distribué (R),
- et un deuxième réflecteur (4) à une deuxième extrémité dudit guide de lumière à distance de ladite section de réseau de manière à constituer un oscillateur laser propre à émettre une dite lumière dont une fréquence centrale peut être commandée par l'intermédiaire de la valeur dudit courant de commande de réseau, un fonctionnement monomode stable de cet oscillateur pouvant être obtenu en commandant une valeur correspondante dudit courant d'accord de phase,
- ce laser étant caractérisé par le fait que ladite couche active (C2) présente une dimension transversale accrue par rapport à ladite section d'amplification dans au moins ladite section de réseau (S2) pour conférer audit laser une plage d'accordabilité continue élargie.

3. Laser selon la revendication 2, caractérisé par le fait que ladite couche active (C2) présente une largeur constante, son épaisseur étant accrue dans lesdites sections d'accord de phase (S3) et de réseau (S2) par rapport à ladite épaisseur d'amplification pour conférer audit laser une plage d'accordabilité continue élargie et une faible largeur de raie.

4. Laser selon la revendication 3, dans lequel ledit guide de lumière (C2, C3) comporte en outre une couche passive (C3) qui s'étend sur toute la longueur de ce guide et qui constitue ladite couche de réseau dans ladite section de réseau (S2).

5. Laser selon la revendication 4, dans lequel une première dite couche de confinement (C1) d'un premier dit type de conductivité, ladite couche active (C2), ladite couche passive (C3), et une deuxième dite couche de confinement (C4) d'un deuxième dit type de conductivité opposé au premier, se suivent selon ladite direction de superposition.

6. Laser selon la revendication 5, caractérisé par le fait que l'épaisseur de ladite couche active (C2) dans ladite section de réseau (S2) est au moins égale à 120% de ladite épaisseur d'amplification.

7. Laser selon la revendication 5, caractérisé par le fait que l'épaisseur de ladite couche active (C2) dans ladite section de réseau (S2) est supérieure à 200 nm.

8. Laser selon la revendication 2, caractérisé par le fait que l'épaisseur de ladite couche active (C2) dans ladite section de réseau (S2) est comprise entre 10 et 25% de la longueur d'onde qu'une lumière susceptible d'être amplifiée dans le matériau de cette couche présente dans ce matériau.

9. Laser selon la revendication 2, caractérisé par le fait qu'il comporte en outre des moyens d'alimentation électrique (6) propres à fournir lesdits courants d'amplification, d'accord de phase et de commande de réseau avec des valeurs propres à assurer ladite amplification dans ladite section d'amplification (S1) et à éviter une amplification de ladite lumière dans lesdites sections d'accord de phase (S3) et de réseau (S2).

**Claims**

1. A tunable semiconductor laser having three sections (S1, S2, S3) which follow one another along a longitudinal direction and which are fed with electric currents (I1, I2, I3) in an independent manner, characterized in that the laser has an increased transverse dimension relative to an amplification section (S1) in a section (S2) provided with a distributed reflector (R), whose equivalent pitch is controlled in order to tune said laser.

2. A tunable semiconductor laser comprising:
   - a monolithic semiconductor wafer (2) extending along a longitudinal direction and consisting of layers (C1, C2, C3, C4) having various compositions and transverse dimensions, said transverse dimensions being widths and thicknesses, said widths being possibly adjacent in a lateral direction, said thicknesses being superposed in a superposition direction, said width and thickness of each of said layers defining a section of said layer, said layers constituting:
   - an internal light guide (C2, C3) extending along said longitudinal direction and interposed in said superposition and lateral directions between confinement layers (C1, C4) having lower refractive indices so as to guide a light beam propagating along said longitudinal direction, said light guide itself comprising at least one active layer (C2) in which a forbidden energy band has a narrower width than in the adjacent layers (C1, C3), a first (C1) and a second (C4) one of said confinement layers having a first and a second type of opposite conductivity so that, if electrical injection currents (I1, I2, I3) pass from one of these two layers to the other along said direction of superposition, said currents pass through said light guide causing densities of free carriers to appear therein capable of producing an optical gain therein and/or of controlling a refractive index therein; and
   - three sections which follow one another along said longitudinal direction and which form:
     - an amplification section (S1) in which said active layer has an amplification thickness capable of ensuring an amplification of said light amplified;
     - a phase tuning section (S3), and
     - a grating section (S2) which is situated at a first end of said light guide and in which the thickness of the grating layer (C3) belonging to said light guide varies in alternation along said longitudinal direction so as to constitute a diffraction grating having a pitch and so that said grating contributes to forming a distributed Bragg reflector (R) for said light having a controllable equivalent pitch, with the ratio of said equivalent pitch to said grating pitch being controllable by means of the controllable refractive index of said active layer in said grating section,
   - amplification electrodes (E1, EC) disposed in said amplification section in order to allow an amplification current to pass, which constitutes an injection current (I1) in order to produce a positive optical gain in said active layer (C2) capable of creating and/or amplifying said light;
   - phase tuning electrodes (E3, EC) disposed in said phase tuning section (S3) in order to allow a phase tuning current (I3) to pass which constitutes an injection current for controlling the refractive index of said active layer (C2), and for controlling thereby the optical length of said phase tuning section relative to said light;
   - grating control electrodes (E2, EC) disposed in said grating section (S2) in order to allow a grating control current (I2) to pass which constitutes an injection current for controlling said equivalent pitch of said distributed reflector (R); and
   - a second reflector (4) at a second end of said light guide at a distance from said grating section so as to constitute a laser oscillator capable of emitting light, a central frequency of which may be controlled by means of the value of said grating control current, with a stable monomode operation of said oscillator being obtainable by controlling a corresponding value of said phase tuning current, characterized in that said active layer (C2) has a tranverse dimension which is increased relative to said amplification section in at least said grating section (S2), in order to impart a widened, continuous tuning range to said laser.

3. A laser according to claim 2, characterized in that said active layer (C2) has a constant width, with its thickness being increased in said grating section (S2) and said phase tuning section (S3) relative to said amplification thickness, in order to impart a widened, continuous tuning range and a narrow spectrum line width to said laser.

4. A laser according to claim 3, in which said light guide (C2, C3) further includes a passive layer (C3) which extends along the entire length of said light guide and which constitutes said grating layer in said grating section (S2).

5. A laser according to claim 4, in which a first one of said confinement layers (C1) of a first conductivity type, said active layer (C2), said passive layer (C3), and a second confinement layer (C4) of a second, opposite conductivity type succeed one another in said superposition direction.

6. A laser according to claim 5, characterized in that the thickness of said active layer (C2) in said grating section (S3) is not less than 120 % of said amplification thickness.

7. A laser according to claim 5, characterized in that the thickness of said active layer (C2) in said grating section (S2) is greater that 200 nm.

8. A laser according to claim 2, characterized in that the thickness of said active layer (C2) in said grating section (S2) amounts to between 10% and 25% of the wavelength of a light which is capable of being amplified in the material of said layer.

9. A laser according to claim 2, characterized in that it further includes electrical feed means (6) capable of providing said amplification, phase tuning, and grating control currents at values capable of ensuring said amplification in said amplification section (s1) and for avoiding amplification of said light in said phase tuning section (S3) and in said grating section (S2).

**Patentansprüche**

1. Abstimmbarer Halbleiterlaser mit drei Abschnitten (S1, S2, S3), die in einer Längsrichtung aufeinander folgen und unabhängig voneinander mit elektrischen Strömen (I1, I2, I3) gespeist werden, dadurch gekennzeichnet, daß der Laser eine vergrößerte Querabmessung seiner aktiven Schicht relativ zu einem Verstärkungsabschnitt (S1) in einem Abschnitt (S2) aufweist, die mit einem verteilten Reflektor (R) versehen ist, dessen äquivalente Teilung zum Abstimmen dieses Lasers gesteuert wird.

2. Abstimmbarer Halbleiterlaser,
    - mit einem monolithischen, halbleitenden Chip (2), der sich entlang einer Längsrichtung erstreckt und aus Schichten (C1, C2, C3, C4) besteht, die unterschiedliche Zusammensetzungen und Querabmessungen besitzen, wobei diese Querabmessungen Breiten und Dicken sind, die Breiten gegebenenfalls entlang einer Seitenrichtung nebeneinander liegen, die Dicken entlang einer Überlagerungsrichtung übereinander geschichtet sind, die Breite und Dicke jeder dieser Schichten einen Abschnitt dieser Schicht definieren und wobei die Schichten so beschaffen sind, daß sie bilden:
    - einen inneren Lichtleiter (C2, C3), der sich entlang der Längsrichtung erstreckt und entlang der Überlagerungsrichtung und der Seitenrichtungen zwischen Einschließungsschichten (C1, C4) eingefügt ist, die geringere Lichtbrechzahlen besitzen, derart, daß sie das sich in dieser Längsrichtung ausbreitende Licht weiterleiten, wobei dieser Lichtleiter seinerseits mindestens eine aktive Schicht (C2) aufweist, in der ein verbotenes Energieband eine geringere Breite als in den benachbarten Schichten (C1, C3) besitzt, wobei eine erste (C1) und eine zweite (C4) der Einschließungsschichten einen ersten und einen zweiten entgegengesetzten Leitungstyp darstellen, damit im Falle, daß die elektrischen Injektionsströme (I1, I2, I3) entlang der Überlagerungsrichtung von einer dieser beiden Schichten zur anderen fließen, sie diesen Lichtleiter durchqueren und dort Dichten freier Ladungsträger erzeugen, die geeignet sind, dort eine Lichtverstärkung herbeizuführen und/oder dort eine Brechzahl zu steuern;
- und drei Abschnitte, die in der Längsrichtung aufeinander folgen, nämlich:
  - ein Verstärkungsabschnitt (S1), bei dem die aktive Schicht eine Verstärkungsdicke besitzt, die geeignet ist, eine Verstärkung des Lichtes zu ermöglichen,
  - ein Phasenabstimmabschnitt (S3),
  - und ein Gitterabschnitt (S2), der an einem ersten Ende des Lichtleiters angeordnet ist und bei dem die Dicke einer zum Lichtleiter gehörenden Gitterschicht (C3) abwechselnd entlang der Längsrichtung variiert, um ein Beugungsgitter mit einer Teilung zu schaffen und um zu erreichen, daß dieses Gitter dazu beiträgt, für das Licht einen verteilten Bragg'schen Reflektor (R) zu bilden, der eine steuerbare äquivalente Teilung besitzt, wobei das Verhältnis dieser äquivalenten Teilung zur Teilung des Gitters durch die steuerbare Lichtbrechzahl der aktiven Schicht in dem Gitterabschnitt steuerbar ist;
- mit Verstärkungselektroden (E1, EC), die im Verstärkungsabschnitt angeordnet sind, um dort einen Verstärkungsstrom fließen zu lassen, der einen Injektionsstrom (I1) bildet, so daß dieser in der aktiven Schicht (C2) eine positive LichtverStärkung herbeiführt, die geeignet ist, das Licht zu erzeugen und/oder zu verstärken,
- mit Phasenabstimmelektroden (E3, EC), die im Phasenabstimmabschnitt (S3) angeordnet sind und dort einen Phasenabstimmstrom (I3) fließen lassen, der einen Injektionsstrom bildet, um die Lichtbrechzahl der aktiven Schicht (C2) zu steuern und so die optische Länge des Phasenabstimmabschnittes gegenüber dem Licht zu steuern,
- mit Gittersteuerelektroden (E2, EC), die im Gitterabschnitt (S2) angeordnet sind, um dort einen Gittersteuerstrom (I2) fließen zu lassen, der einen Injektionsstrom zum Steuerung der äquivalenten Teilung des verteilten Reflektors (R) bildet,
- und mit einem zweiten Reflektor (4) an einem zweiten Ende des Lichtleiters im Abstand vom Gitterabschnitt, derart, daß ein Laseroszillator gebildet wird, der geeignet ist, ein Licht auszusenden, dessen Mittenfrequenz durch den Wert des Gittersteuerstromes gesteuert werden kann, wobei ein stabiler Monomodebetrieb des Oszillators durch Steuern eines entsprechenden Wertes des Phasenabstimmstroms erzielt werden kann, dadurch gekennzeichnet, daß die aktive Schicht (C2) eine Querabmessung besitzt, die relativ zum Verstärkungsabschnitt in mindestens dem Gitterabschnitt (S2) vergrößert ist, um für den Laser einen verbreiterten kontinuierlichen Abstimmbereich zu schaffen.

3. Laser nach Anspruch 2, dadurch gekennzeichnet, daß die aktive Schicht (C2) eine konstante Breite besitzt, während ihre Dicke im Phasenabstimmabschnitt (S3) und im Gitterabschnitt (S2) relativ zur Verstärkungsdicke vergrößert ist, um für den Laser einen verbreiterten, kontinuierlichen Abstimmbereich und eine geringe Spektrallinienbreite zu schaffen.

4. Laser nach Anspruch 3, bei dem der Lichtleiter (C2, C3) weiter eine passive Schicht (C3) umfaßt, die sich über die gesamte Länge dieses Leiters erstreckt und die Gitterschicht im Gitterabschnitt (S2) bildet.

5. Laser nach Anspruch 4, bei dem eine erste Einschließungsschicht (C1) eines ersten Leitungstyps, die aktive Schicht (C2), die passive Schicht (C3) und eine zweite Einschließungsschicht (C4) eines zweiten, dem ersten Typ entgegengesetzten Leitungstyps entlang der Überlagerungsrichtung aufeinander folgen.

6. Laser nach Anspruch 5, dadurch gekennzeichnet, daß die Dicke der aktiven Schicht (C2) im Gitterabschnitt (S2) mindestens 120 % der Verstärkungsdicke entspricht.

7. Laser nach Anspruch 5, dadurch gekennzeichnet, daß die Dicke der aktiven Schicht (C2) im Gitterabschnitt (S2) größer als 200 nm ist.

8. Laser nach Anspruch 2, dadurch gekennzeichnet, daß die Dicke der aktiven Schicht (C2) im Gitterabschnitt (S2) zwischen 10% und 25% der Wellenlänge liegt, die das im Material dieser Schicht zu verstärkende Licht in diesem Material aufweist.

9. Laser nach Anspruch 2, dadurch gekennzeichnet, daß er weiter elektrische Speiseeinrichtungen (6) aufweist, die geeignet sind, den Verstärkungsstrom, den Phasenabstimmstrom und den Gittersteuerstrom mit Werten zu liefern, die die Verstärkung im Verstärkungsabschnitt (S1) bewirken und die eine Verstärkung des Lichtes im Phasenabstimmabschnitt (S3) und im Gitterabschnitt (S2) verhindern.

# FIG.1

# FIG.2